# EUROPÄISCHE PATENTANMELDUNG

(11) **EP 2 525 214 A1**
(43) Veröffentlichungstag der Anmeldung: **21.11.2012**
(21) Anmeldenummer: 12154316.9
(22) Anmeldetag: 07.02.2012
(51) Int. Cl.: G01N 24/08

(54) **Verfahren zur Analyse komplexer Naturstoffgemische mittels magnetischer Kernresonanz Spektroskopie**

(30) Priorität: 14.05.2011 DE 102011116839
(71) Anmelder: ALNuMed UG (haftungsbeschränkt), 95448 Bayreuth (DE)
(72) Erfinder: Schwarzinger, Stephan, 95448 Bayreuth (DE); Hofmann, Rainer, 95509 Marktschorgast (DE)
(74) Vertreter: Hofstetter, Schurack & Partner

(57) **Zusammenfassung**

Die Erfindung betrifft ein Verfahren zur Analyse eines komplexen Naturstoffgemischs, welches als Hauptbestandteil zumindest ein Saccharid umfasst, mittels NMR-Spektroskopie, bei welchem zumindest ein eindimensionales NMR-Spektrum, insbesondere ein ¹H-Spektrum, des Naturstoffgemischs aufgenommen wird, wobei das NMR-Spektrum ohne Wasserunterdrückung aufgenommen wird. Auf einfachste Weise kann so schnell und kostengünstig sowohl das Vorliegen bestimmter Substanzen in der Probe nachgewiesen als auch quantifiziert werden. Vergleiche mit Referenzdatenbanken erlauben auch komplexere Aussagen, beispielsweise betreffend die geographische Herkunft eines Produkts.

## Beschreibung

Die vorliegende Erfindung betrifft ein Verfahren nach dem Oberbegriff des Anspruchs 1. Die Erfindung umfasst ein Verfahren zur Ermittlung von mindestens einem Qualitätsmerkmal in komplexen Naturstoffgemischen wie Honig mittels magnetischer Kernresonanz (Spektroskopie NMR, Nuclear Magnetic Resonance) gezeigt am Beispiel der Ermittlung des Wassergehaltes als Parameter für die Haltbarkeit und des Gehaltes von Hydroxymethylfurfural (HMF) als Parameter für übermäßige Hitzebehandlung oder Überlagerung.

Honig ist ein hochwertiges Naturprodukt, das sich aus einer Vielzahl an Stoffen zusammensetzt. Es unterliegt unter anderem betreffend Herstellung, Benennung, Mindest- oder Höchstmengen an Inhaltsstoffen und Inverkehrbringen gesetzlichen Vorschriften, in Deutland der Honigverordnung (HonigV, Fassung vom 16.1.2004, geändert am 8.8.2007). Neben dem Geschmack sind die Stoffe für die Konsistenz, das Aussehen und die Veränderung der Konsistenz während der Lagerung mit verantwortlich. Für Honig, zumindest aber für bestimmten Inhaltsstoffe, wurde eine positive Auswirkung auf die Gesundheit beschrieben (Otolaryngology-Head and Neck Surgery (2009) 141, 114-118; Analytical Methods (2010) 2, 1479-1483). Während die meisten Stoffe in Honig natürlichen Ursprungs sind, können auch Stoffe aus der Verarbeitung, wie Zusätze (natürlicher oder künstlicher Art, wie beispielsweise Zucker wie Saccharose, Glucose, Fructose, etc.) oder Umwandlungsprodukte (wie beispielsweise 5-Hydroxymethylfurfural = HMF), sowie natürliche oder künstliche Stoffe oder deren Umwandlungsprodukte, die im Zuge der natürlichen Honigentstehung durch Imker oder Bienen eingetragen werden, wie beispielsweise Pflanzenschutzmittel oder Mittel zur Behandlung von Bienenstöcken gegen die Varroa-Milbe (z.B. Ameisensäure, Milchsäure, Oxalsäure, Thymol, etc.) (HonigV; http://www.lwg.bayern.de/bienen/info/krankheiten/25553/linkurl 0 26.pdf; http://www.stmelf.bayern.de/agrarpolitik/programme/foerderwergweiser/11017/merkblatt.pdf). Viele dieser Stoffe unterliegen einer gesetzlich regulierten mengenmäßigen Beschränkung. Beispielsweise regelt die HonigV den Mindestgehalt an bestimmten Zuckersorten, den Höchstgehalt an Wasser, den Höchstgehalt an HMF, etc. Daher besteht der Bedarf an einer robusten qualitativen und quantitativen Analytik. Dies gilt insbesondere, wenn das Produkt aus biologischer Herstellung stammt und daher vom Kunden als besonders hochwertig angesehen werden kann.

Ein Beispiel für einen wichtigen Qualitätsparameter ist der Wassergehalt von Honig. Ist dieser zu hoch, beginnt das Produkt zu vergären, wodurch es zur Bildung neuer metabolischer Abbauprodukte kommt (beispielsweise Alkohole) und Geschmack und Geruch des Honigs sich nachteilig verändern. Eine Analytik kann in einfacher Weise mittels Refraktometrie bewerkstelligt werden, deren Genauigkeit aber typischerweise im Prozentbereich limitiert ist. Auch ist es mittels Refraktometrie nicht möglich, den Anteil an Gärungsprodukten zu messen.

Ein Beispiel für ein Umwandlungsprodukt, das aus natürlichen Stoffen entsteht und einer gesetzlichen Regulierung unterliegt, ist die Verbindung 5-Hydroxymethylfurfural (HMF). HMF entsteht durch eine chemische Umwandlung aus Zuckern, im Fall von Honig in der Regel durch Umwandlung von Fructose. Diese Reaktion verläuft mit steigender Temperatur schneller, sodass der Gehalt von HMF im Honig steigt. Der Gehalt von HMF korreliert mit der Lagerdauer und der Aussetzung bei höheren Temperaturen. Die Behandlung bei höheren Temperaturen von teilweise > 60 °C ist ein erheblicher Bestandteil unter anderem bei der industriellen Herstellung von Honig, bei der Honig zur Einstellung einer bestimmten Konsistenz und/ oder zur Erreichung einer längeren Haltbarkeit erhitzt wird. Bei großen Gebinden sind dabei entsprechend lange Expositionen einzuhalten, während derer HMF entstehen kann. Der Nachweis von HMF erfolgt üblicherweise chromatographisch, gegebenenfalls nach einer Derivatisierung. Dabei ist zu erwähnen, dass es Stoffe gibt, die sich mit den angegeben Trenn-/ Nachweisverfahren nicht oder nur schlecht von HMF unterscheiden lassen. Hierzu können Honig-eigene Stoffe gehören, aber auch Stoffe wie das Schimmelpilz-Toxin Patulin (http://www.vis.bayern.de/ernaehrung/lebensmittelsicherheit/unerwuenschte stoffe/patulin.htm; J. Chromatogr. A (1999) 847, 69-74).

Eine umfassende Analyse von Honig beinhaltet unter anderem auch die Bestimmung der im Honig vorhandenen Zuckerarten und deren Verhältnisse (Einfluss auf Kristallisation, Konsistenz, Geschmack, Nachbehandlung, Zusatz), die Bestimmung von Enzymaktivitäten (z.B. Invertase (HonigV)), die Charakterisierung und Quantifizierung von kleinen organischen Molekülen, die Analyse von Pollen (Herkunft, Honigsorte, beispielsweise mittels SNIF-NMR Isotopenanalyse (J. Agric. Food Chem (1996) 44, 139-140)).

Die magnetische Kernresonanz (NMR) Spektroskopie gehört zu den Methoden der Magnetresonanz-Methoden, von denen beispielsweise auch die Elektronenspinresonanz für Haltbarkeitsuntersuchungen flüssiger Lebensmittel Anwendung findet (EP1151316 27.10.2005). Auch die NMR Spektroskopie findet Einsatz bei der Analyse von Lebensmitteln, wie der Multiparameterbestimmung in Fruchtsäften mittels metabonomischer Analyse (SGF Profiling™, http://www.bruker-biospin.com/juicescreener-dir.html), der Bestimmung von Isotopenmustern zur Herkunfts- und Sortenbestimmung von Honig (J. Agric. Food Chem (1996) 44, 139-140), oder dem qualitativen Nachweis von Inhaltsstoffen wie Aminosäuren (Anal. Chem. (2005) 77, 2455-2463) oder pharmakologisch relevanten Inhaltsstoffen in Honig (Analytical Methods (2010) 2, 1479-1483). NMR Spektroskopie wurde ferner verwendet, um Zusätze fremder Zuckerarten zu analysieren (J. Agric. Food Chem. (2002) 50(7), 1751-1764).

Nachteilig an diesem bekannten Ansatz sind einerseits die Probleme zur eindeutigen Identifizierung und Quantifizierung von Stoffen (vgl. Beispiel HMF / Patulin) sowie andererseits die Erfordernis, dass Stoffe einer zeitaufwändigen Aufarbeitung unterzogen werden müssen (Trennung, Derivatisierung für den analytischen Nachweis und die Quantifizierung), sowie weiterhin der Umstand, dass für die einzelnen Qualitätsparameter verschiedene Verfahren herangezogen werden müssen und dadurch die umfassende Charakterisierung von Honig technisch, zeitlich und finanziell sehr aufwändig wird.

Der vorliegenden Erfindung liegt somit die Aufgabe zugrunde, ein schnelles und kostengünstiges Analyseverfahren für komplexe Naturstoffgemische nach dem Oberbegriff von Patentanspruch 1 bereitzustellen.

Diese Aufgabe wird durch ein Verfahren mit den Merkmalen des Patentanspruchs 1 gelöst. Vorteilhafte Ausgestaltungen der Erfindung sind in den Unteransprüchen beschrieben.

Die Verwendung der magnetischen Kernresonanzspektroskopie (NMR) bietet den technischen Vorteil, Stoffe ohne vorherige Trennung und Derivatisierung direkt in einer Mischung identifizieren und gleichzeitig besonders genau quantifizieren zu können (mindestens gleichwertige Genauigkeit wie bestehende Methoden). Die Analyse kann dabei mittels sogenannter Lösungs-NMR erfolgen, oder aber mittels Festkörper-NMR in festen oder hoch-viskosem Zustand. Das Verfahren erlaubt eine verbesserte Analytik (im Sinne von eindeutiger Nachweise/ Unterscheidung ähnlicher Stoffe), bei verbesserter Genauigkeit und reduziertem Zeitbedarf bedingt durch technische Verfahrensvorteile sowie parallele Bestimmung von Parametern. Die Honig-Analytik wird dadurch technisch wesentlich vereinfacht und verbessert. Die technischen Vorteile des Verfahrens bewirken insgesamt einen höheren Durchsatz und bei paralleler Bestimmung von Parametern neben verbesserter Analysenqualität einen Zeitgewinn und letztendlich eine Reduktion der Analysenkosten.

Überraschenderweise hat es sich herausgestellt, dass ein Verzicht auf eine Wasserunterdrückung oder auch auf die Unterdrückung der Signale anderer, dominanter Hauptbestandteile, wie beispielsweise von Sacchariden in Honigproben, deutliche Vorteile für die Analytik komplexer Naturstoffgemische mit sich bringt. Zunächst erlaubt eine solcherart gestaltete Messung die quantitative Erfassung des Wassergehaltes durch Integration über das Wassersignal. Gleiches gilt selbstverständlich für andere Komponenten, wie beispielsweise Zucker, die bei aus dem Stand der Technik bekannten Analyseverfahren ebenfalls unterdrückt werden.

Trotz des Einflusses intensiver Signale von Wasser und anderen Hauptbestandteilen des Gemisches auf die Empfängerverstärkung ist es dennoch möglich, mit dem beschriebenen Verfahren auch schwache Signale von Spurenkomponenten zu detektieren. Mit nur einer Messung können somit sowohl quantitative als auch qualitative Aussagen über das untersuchte Naturstoffgemisch getroffen werden.

In einer vorteilhaften Ausgestaltung des erfindungsgemäßen Verfahrens wird zur Aufnahme des NMR-Spektrums ein breitbandiger Anregungspuls verwendet.

Es ist dabei zweckmäßig, das Naturstoffgemisch vor der Messung zu verdünnen, insbesondere um für die Messung relevante Zusatzstoffe wie Puffer, Referenzsubstanzen und dergleichen zuzufügen. Um die zuverlässige Bestimmung von Spurensubstanzen zu erlauben, sollte die Endkonzentration an Naturstoffgemisch in der Probe jedoch nicht weniger als 25%, insbesondere nicht weniger als 50% betragen. Trotz der insbesondere bei Honig noch sehr hohen Viskosität solcher Proben lassen sich auf diese Weise Spektren mit guter Auflösung und hoher Sensitivität für Spurensubstanzen gewinnen. Zum verdünnen kann ¹H₂O oder ein davon verschiedenes Lösungsmittel verwendet werden.

Die Pufferung des Naturstoffgemisches erfolgt vorzugsweise auf einen pH-Wert zwischen 2 und 7, insbesondere auf einen pH-Wert zwischen 3,5 und 6, was im Falle von Honig in etwa dem natürlichen pH des Stoffgemischs entspricht. Durch die Zugabe einer Puffersubstanz wird vermieden, dass der pH-Wert während der Messung driftet, was zu einer unerwünschten Verschlechterung der Spektrenqualität führen könnte. Als Puffer können ein Phosphat-, Acetat- oder Formiatpuffer eingesetzt werden, da diese Substanzen mikrobielles Wachstum und Gärungsprozesse in der Probe in der Regel nicht fördern. Die Verwendung deuterierter Puffersubstanzen vermeidet dabei das Auftreten unerwünschter Signale im Spektrum. Es ist ferner zweckmäßig, wenn die Puffersubstanz den Austausch zwischen den Zucker-OH- und Wasserprotonen stabilisiert.

Neben den Puffersubstanzen werden der Probe vor der Messung zweckmäßigerweise noch Referenzsubstanzen zugesetzt. Insbesondere Substanzen mit wohldefinierter chemischer Verschiebung, die zum Referenzieren des Spektrums geeignet sind, sowie Substanzen, die im Spektrum klar identifizierbare, vereinzelte Peaks hervorrufen und damit als Norm für eine Quantifizierung der Spektren geeignet sind, bieten sich hierfür an. Beispiele hierfür sind DSS, TSP, Dioxan, TMS oder ähnliche, an sich bekannte Referenzsubstanzen.

Um mikrobielles Wachstum in der Probe zu vermeiden, kann ferner Azid zugesetzt werden.

Die Zahl der aufzunehmenden Einzelspektren, die aufsummiert und gemittelt werden, richtet sich nach der gewünschten Sensitivität. In der Regel kann hierfür das gewünschte Signal-Rausch-Verhältnis geräteunabhängig vorgegeben werden.

Zur Auswertung des aufgenommenen Spektrums existieren verschieden Möglichkeiten, die alternativ oder gleichzeitig am selben Spektrum Anwendung finden können. Zunächst ist es möglich, das Vorliegen einer Substanz anhand zumindest eines isolierten, für die Substanz charakteristischen Peaks nachzuweisen. Der Anteil einer Substanz im Stoffgemisch kann ferner durch Integration über einen solchen Peak bestimmt werden. Komplexere Aussagen, beispielsweise betreffend die Herkunft eines biologischen Naturstoffgemischs wie Honig, können getroffen werden, indem das Spektrum mit einer Datenbank von Referenzspektren verglichen wird. Hierfür können Methoden der Mustererkennung und Statistik, wie beispielsweise die Hauptkomponentenanalyse, Anwendung finden. Dabei kann das ermittelte Spektrum mit einer Datenbank von Spektren definierter Naturstoffgemische und/oder Naturstoffgemischen bekannter Herkunft verglichen werden. Auf Grundlage des Vergleichs kann das Vorliegen und/oder Nichtvorliegen zumindest einer Substanz in dem Naturstoffgemisch bestimmt werden. Des Weiteren kann auf Grundlage des Vergleichs eine geographische Herkunft des Naturstoffgemischs bestimmt werden. Schließlich ist es möglich, auf Grundlage des NMR-Spektrums die Konzentration wenigstens einer Substanz in dem Naturstoffgemisch zu bestimmen.

Im Folgenden werden die Erfindung und ihre Ausführungsformen anhand der Zeichnung näher erläutert. Es zeigen:
- Fig. 1:: ¹H-NMR-Spektren von Honig vor und nach Erhitzen unter Bildung von Hydroxymethylfurfural;
- Fig. 2:: eine Ausschnittsvergrößerung des Spektrums gemäß Fig. 1 zur Veranschaulichung der HMF-typischen Signale, und
- Fig. 3:: ¹H-NMR-Spektren von Honig vor und nach Wasserzugabe.

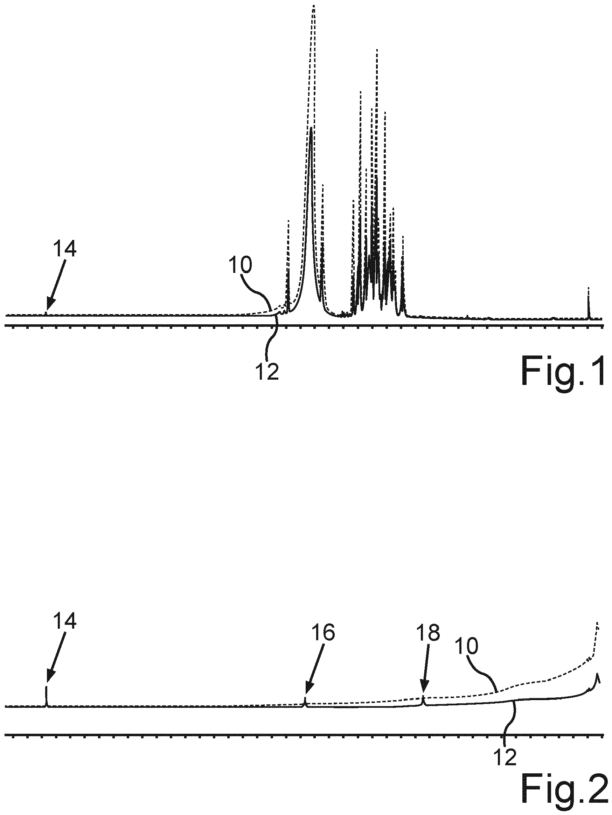

Figuren 1 und 2 demonstrieren die Verwendung eines Ausführungsbeispiels des erfindungsgemäßen Verfahrens zum Nachweis von Hydroxymethylfurfural in Honig. Zur Anregung der HMF-Bildung wurde eine Probe bei 95°C gelagert, während die Vergleichsprobe bei Raumtemperatur gelagert wurde. Für beide Messungen wurde der Honig zu 50% (v/v) mit Wasser verdünnt. Die Messungen wurden auf einem 400 MHz-Spektrometer (Bruker Avance 400 mit TXI Probenkopf) bei 298K unter Verwendung von DSS als interner Referenz durchgeführt.

Der nicht wärmebehandelte Honig ist in Spektrum 10 dargestellt, während das Spektrum 12 die Probe nach Wärmebehandlung zeigt. Es ist deutlich zu erkennen, dass nach dem Erhitzen neue Peaks 14, 16, 18 auftreten, die typisch für Hydroxymethylfurfural sind.

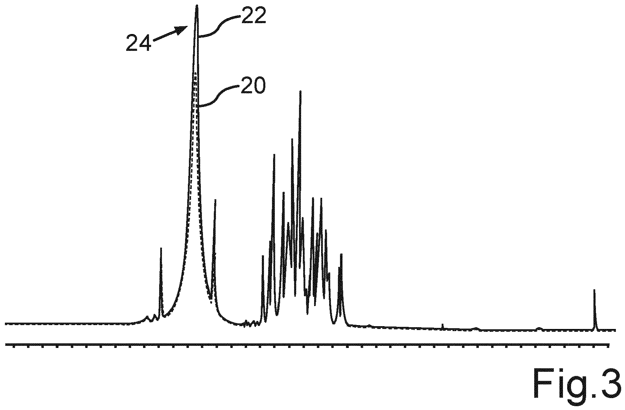

Um die Verwendung eines Ausführungsbeispiels des erfindungsgemäßen Verfahrens zur Quantifizierung von Inhaltsstoffen zu demonstrieren, wurden Protonen-NMR-Spektren einer Honigprobe bei unterschiedlicher Verdünnung aufgenommen. Das in Fig. 3 dargestellte Spektrum 20 zeigt dabei die Probe vor Verdünnung, das überlagerte Spektrum 22 nach Verdünnung mit 2% (v/v) Wasser. Auch hier erfolgte die Aufnahme auf einem 400 MHz-Spektrometer (Bruker Avance 400 mit TXI Probenkopf) bei 298K unter Verwendung von DSS als interner Referenz.

Die Überlagerung der beiden Spektren zeigt deutlich den Einfluss der zusätzlichen Verdünnung auf das Wassersignal 24 bei 4,85 ppm. Es ist ferner deutlich zu erkennen, dass trotz des nicht unterdrückten Wassersignals auch weitere Signale von in geringer Konzentration erkennbaren Komponenten detektierbar sind.

Neben den geschilderten Ausführungsbeispielen sind selbstverständlich weitere Möglichkeiten im Rahmen des erfindungsgemäßen Verfahrens gegeben. So kann beispielsweise ein Vergleich des Spektrums mit einer Datenbank von Referenzspektren genutzt werden, um Aussagen über die Zusammensetzung, geographische Herkunft oder dgl. einer Probe zu treffen. Zusätzlich zu den gezeigten Protonenspektren ist auch Kohlenstoff ¹³C ist für dieses Verfahren nutzbar.

Das Verfahren ist im Übrigen auf andere Stoffe im Honig anwendbar, wie die einleitend erwähnten Stoffe zur Behandlung gegen Varroen, zum Nachweis von anderen Naturstoffen wie Pilz-Toxinen, zum Nachweis von Herbiziden, Fungiziden oder anderen regulierten Substanzen, zum Nachweis von Stoffen, die geschmacksbestimmend und/ oder geruchsbestimmend sind, zum Nachweis von Stoffen, die herkunftsbestimmend sind, zum Nachweis von Stoffen, welche die Konsistenz, Farbe und Beschaffenheit des Honigs beeinflussen, zum Nachweis von Stoffen, die den Beginn einer Vergärung anzeigen/ den Fortschritt einer Vergärung beschreiben, sowie zum Nachweis von Stoffen, die den Beginn oder den Verlauf einer anderen biologischen oder technischen Umwandlung oder Bearbeitung beschreiben.

Das Verfahren ist ferner auf andere Produkte anwendbar, bei denen biologische oder technische Prozesse (einschließlich Lagerung und/ oder Transport) eine Veränderung von Inhaltsstoffen stattfindet, wie beispielsweise Produkte, die Fruchtzucker (Fructose) enthalten, aus der sich HMF oder andere Umwandlungsprodukte bilden können, Produkte, die andere Zucker enthalten, die zu HMF oder anderen Stoffen umgesetzt werden können.

Solche Produkte schließen beispielsweise fruchtbasierte Getränke mit Alkohol, alkoholische Getränke mit Zusatz von Zucker (Fructose, Glucose, Saccharose, etc.), Fruchtsaft-Sirupe, Sirupe im Allgemeinen (beispielsweise Ahornsirup, Melasse, etc.), umgewandelte Zuckerprodukte wie Karamell, Produkte mit und aus Polysacchariden wie beispielsweise Zellulose, Marmeladen, Konfitüren, Fruchtaufstriche, etc. ein.

Grundsätzlich ist die Methode auf Produkte anwendbar, bei denen mehrere Qualitäts- oder Prozessparameter gleichzeitig qualitativ und/ oder quantitativ erfasst werden, wie beispielsweise Wasser, ein oder mehrere verschiedene Alkohole, Dextrine, Kohlenwasserstoffe, Aldehyde, Lactone, Ketone, aromatische Verbindungen, heterozyklische Verbindungen, Naturstoffe und deren prozessbedingte Derivate, sowie beliebige Kombinationen dieser Stoffe. Ein Beispiel hierfür ist die simultane Bestimmung des Gehaltes von Wasser, Ethanol, Methanol und Essigverbindungen in Destillaten wie Wein- und Fruchtbränden.

## Patentansprüche

1. Verfahren zur Analyse eines komplexen Naturstoffgemischs, welches als Hauptbestandteil zumindest ein Saccharid umfasst, mittels NMR-Spektroskopie, bei welchem zumindest ein eindimensionales NMR-Spektrum, insbesondere ein ¹H-Spektrum, des Naturstoffgemischs aufgenommen wird,
**dadurch gekennzeichnet, dass**
das NMR-Spektrum ohne Wasserunterdrückung aufgenommen wird.

2. Verfahren nach Anspruch 1,
**dadurch gekennzeichnet, dass**
zur Aufnahme des NMR-Spektrums ein breitbandiger Anregungspuls verwendet wird.

3. Verfahren nach Anspruch 1 oder 2,
**dadurch gekennzeichnet, dass**
das Naturstoffgemisch vor Aufnehmen des NMR-Spektrums um nicht mehr als 75%, vorzugsweise nicht mehr als 50% verdünnt wird.

4. Verfahren nach Anspruch 3,
**dadurch gekennzeichnet, dass**
zum Verdünnen ein von ¹H₂O verschiedenes Lösungsmittel verwendet wird.

5. Verfahren nach einem der Ansprüche 1 bis 4,
**dadurch gekennzeichnet, dass**
der pH-Wert des Naturstoffgemischs auf einen Wert zwischen 3,5 und 6 gepuffert wird.

6. Verfahren nach Anspruch 5,
**dadurch gekennzeichnet, dass**
zum Einstellen des pH-Werts ein Phosphat- und/oder Acetat- und/oder Formiatpuffer verwendet wird.

7. Verfahren nach einem der Ansprüche 1 bis 6,
**dadurch gekennzeichnet, dass**
das Naturstoffgemisch mit einer Referenzsubstanz zum Bestimmen der chemischen Verschiebung in einer vorgegebenen Konzentration versetzt wird.

8. Verfahren nach einem der Ansprüche 1 bis 7,
**dadurch gekennzeichnet, dass**
das Spektrum mit einer Datenbank von Spektren definierter Naturstoffgemische verglichen wird.

9. Verfahren nach Anspruch 8,
**dadurch gekennzeichnet, dass**
auf Grundlage des Vergleichs das Vorliegen und/oder Nichtvorliegen zumindest einer Substanz in dem Naturstoffgemisch bestimmt wird.

10. Verfahren nach Anspruch 8 oder 9,
**dadurch gekennzeichnet, dass**
auf Grundlage des Vergleichs eine geographische Herkunft des Naturstoffgemischs bestimmt wird.

11. Verfahren nach einem der Ansprüche 1 bis 10,
**dadurch gekennzeichnet, dass**
auf Grundlage des NMR-Spektrums die Konzentration wenigstens einer Substanz in dem Naturstoffgemisch bestimmt wird.
